# EUROPEAN PATENT APPLICATION

(11) **EP 3 621 151 A1**
(43) Date of publication of application: **11.03.2020**
(21) Application number: 18827879.0
(22) Date of filing: 27.02.2018
(51) Int. Cl.: H01Q 1/14, H01Q 1/38, H05K 1/02

(54) **ANTENNA DEVICE**

(30) Priority: 07.07.2017 JP 2017133633
(71) Applicant: Fujikura Ltd., Tokyo 135-8512 (JP)
(72) Inventor: AWAJI, Daisuke, Sakura-shi Chiba 285-8550 (JP)
(74) Representative: Maiwald Patent- und Rechtsanwaltsgesellschaft mbH
(86) International application number: PCT/JP2018/007149
(87) International publication number: WO 2019/008821

(57) **Abstract**

To reduce a dielectric loss while determining a direction of an antenna formed on a flexible board.

An antenna device includes: a flexible board including an antenna and a signal line coupled to the antenna, the antenna and the signal line being formed on a front surface side of the flexible board; and a support that puts the flexible board in a predetermined shape, the support having a shape that does not cover at least a part of a second region of a back surface of the flexible board, the second region corresponding to a first region in which the antenna and the signal line are formed.

## Description

### Technical Field

The present disclosure relates to an antenna device.

### Background Art

In recent years, a technique for communication in a millimeter wave band has been developed in order to transmit and receive much information in wireless communication. When a signal in a high frequency band such as a millimeter wave band is transmitted, a conductive loss and a dielectric loss increase in an antenna and the like. Thus, an antenna and the like are commonly formed on a board having a small dielectric loss (for example, see Patent Literature 1).

### Citation List

### Patent Literature

Patent Literature 1: Japanese Patent Application Publication No.2015-8286

### Summary of Invention

### Technical Problem

Herein, for example, a board having a small dielectric loss and capable of adjusting a direction in which a radio wave is radiated from an antenna includes a flexible printed board (hereinafter simply referred to as a flexible board) using a liquid crystal polymer. When an antenna is formed on such a flexible board, a dielectric loss of the antenna can be reduced, but a direction (a radiation direction of a radio wave) of the antenna needs to be determined. Thus, for example, a printed board may be bonded to a back surface of a flexible board that includes an antenna formed on a front surface thereof. However, in such a case, a dielectric loss in the antenna and the like may deteriorate due to an effect of the printed board.

Thus, an object of the present disclosure is to provide a technique capable of reducing a dielectric loss while determining a direction of an antenna formed on a flexible board.

### Solution to Problem

A primary aspect of the present disclosure is an antenna device comprising: a flexible board including an antenna and a signal line coupled to the antenna, the antenna and the signal line being formed on a front surface side of the flexible board; and a support that puts the flexible board in a predetermined shape, the support having a shape that does not cover at least a part of a second region of a back surface of the flexible board, the second region corresponding to a first region in which the antenna and the signal line are formed.

### Advantageous Effects of Invention

According to the present disclosure, it is possible to reduce a dielectric loss while determining a direction of an antenna formed on a flexible board

### Brief Description of Drawings

[Fig. 1] Fig. 1 is a perspective view of an antenna device 10.
[Fig. 2] Fig. 2 is a perspective view of a board unit 20 on a front surface side.
[Fig. 3] Fig. 3 is a perspective view of the board unit 20 on a back surface side.
[Fig. 4] Fig. 4 is a perspective view of a support 60.
[Fig. 5] Fig. 5 is a schematic diagram for illustrating a bonding state.
[Fig. 6] Fig. 6 is a perspective view of an antenna device 11.
[Fig. 7] Fig. 7 is a perspective view of a support 61.
[Fig. 8] Fig. 8 is an exploded perspective view of the support 61.
[Fig. 9] Fig. 9 is a perspective view of an antenna device 12.
[Fig. 10] Fig. 10 is a perspective view of a support 62.
[Fig. 11] Fig. 11 is a cross-sectional view of the antenna device 12 taken along an A-A line of Fig. 9.
[Fig. 12] Fig. 12 is a perspective view of a support 65.

### Description of Embodiments

### Antenna Device 10 (First Embodiment)

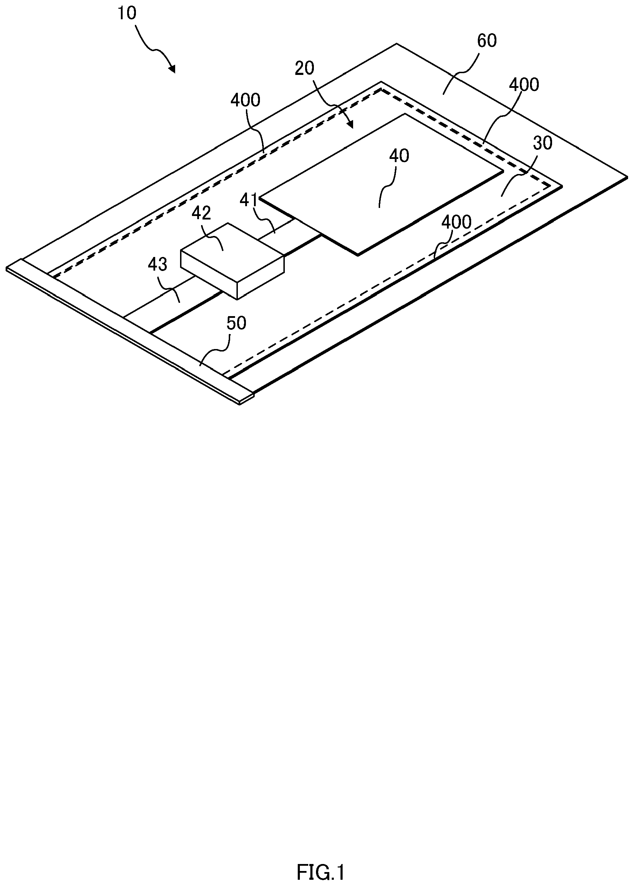

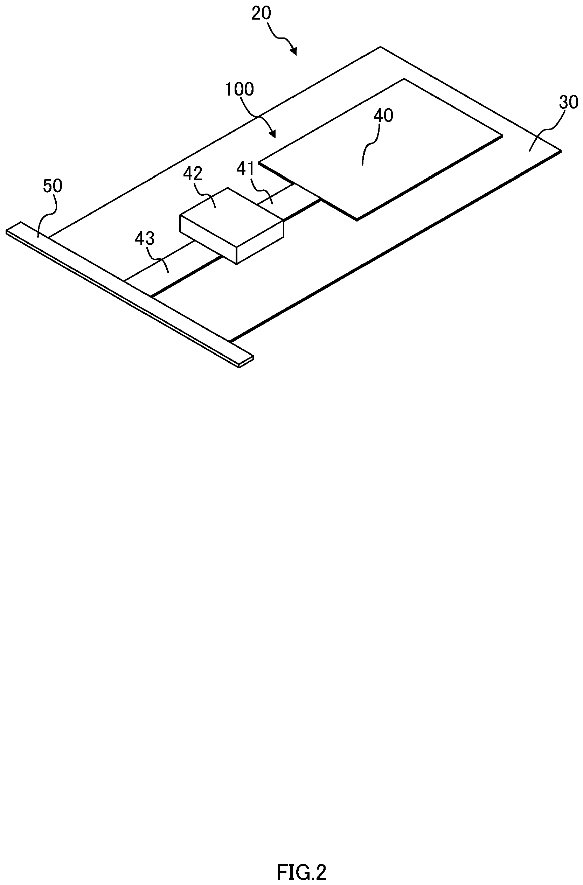

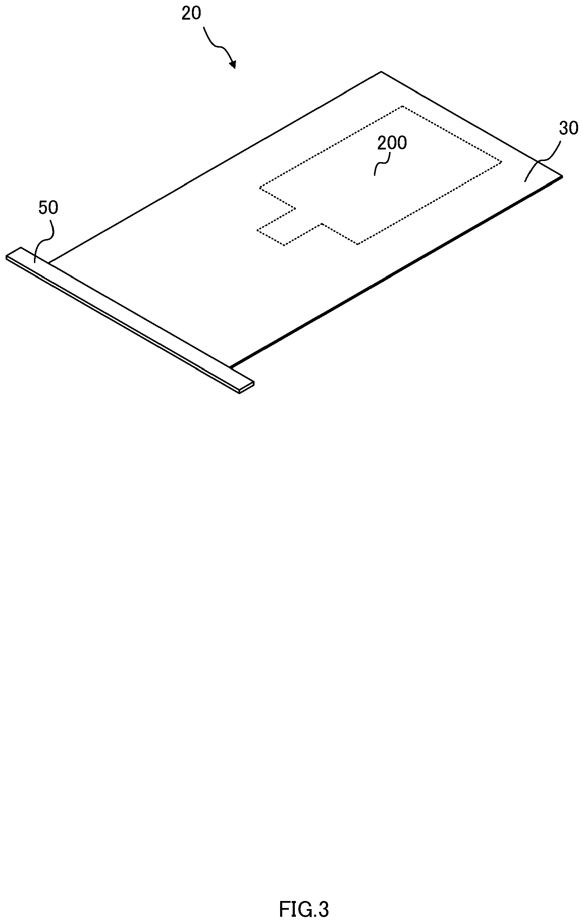

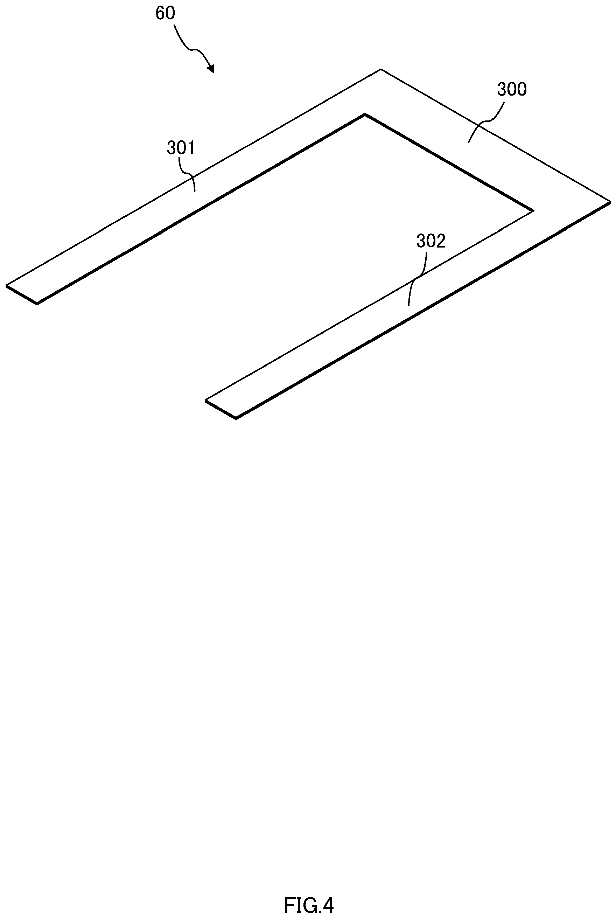

Fig. 1 is a perspective view illustrating a configuration of an antenna device 10. The antenna device 10 is a device used for transmitting and receiving a millimeter-wave radio wave, and includes a board unit 20 illustrated in Figs. 2 and 3 and a support 60 illustrated in Fig. 4. Fig. 2 is a perspective view of the board unit 20 on a front surface side.

The board unit 20 is a unit for transmitting and receiving a radio wave in the antenna device 10, and includes a flexible board 30, an antenna 40, a signal line 41, an integrated circuit (IC) 42, a wiring 43, and a connector 50.

The flexible board 30 is a multilayer film-shaped printed wiring board formed of a liquid crystal polymer as a material, for example, and various components are mounted on the flexible board 30.

The antenna 40 is a metal foil patterned on the front surface of the flexible board 30, and transmits and receives a millimeter-wave radio wave.

The signal line 41 is a wiring though which a signal received by the antenna 40 or a signal to be transmitted from the antenna 40 is transmitted, and is patterned on the front surface of the flexible board 30. Note that a region of the flexible board 30 in which the antenna 40 and the signal line 41 are formed is referred to as a region 100 in an embodiment of the present disclosure. Then, a signal in a millimeter wave band is transmitted though the antenna 40 and the signal line 41, and thus a dielectric loss occurs in the region 100.

Note that a metal pattern for ground (GND), which is not illustrated, is provided below the signal line 41 and the wiring 43, in a layer inside the flexible board 30. The antenna 40 and the signal line 41 are formed on the front surface of the flexible board 30 and covered with a protective film (not illustrated) made of resin, but the present disclosure is not limited thereto. For example, the antenna 40 and the signal line 41 may be patterned on an inner layer close to the front surface of the flexible board 30. In other words, the antenna 40 and the signal line 41 only have to be provided on the front surface side of the flexible board 30 such that the antenna device 10 can transmit and receive a predetermined radio wave.

The IC 42 is a wireless communication circuit that processes a radio wave transmitted and received in the antenna 40, and transmits and receives a millimeter wave signal with the antenna 40 while transmitting and receiving a base band signal with the connector 50.

The wiring 43 is a plurality of wirings that connect the IC 42 to the connector 50, and includes, for example, a wiring that transmits a base band signal and a wiring that supplies power for operating the IC 42. Note that Figs. 1, 2, and the like illustrate the wiring 43 as one single pattern for convenience, but the wiring 43 includes the plurality of wirings as described above.

The connector 50 is a component connected to a control device (not illustrated) for operating the antenna device 10, for example, and is provided on an end part on an end side of the flexible board 30. Note that the connector 50 is provided with, for example, a plurality of pins, which are omitted for convenience.

Fig. 3 is a perspective view of the board unit 20 on a back surface side. Fig. 3 illustrates a region 200 (second region) of the back surface, the region corresponding to the region 100 (first region) of the front surface of the flexible board 30. A dielectric loss increases when a rigid board or the like that supports the flexible board 30 are bonded to the region 200 of the back surface. Thus, as described later in detail, a support in an embodiment of the present disclosure has such a shape that does not cover at least a part of the region 200 to reduce a dielectric loss.

Fig. 4 is a perspective view of the support 60. The support 60 is a member that supports the flexible board 30 and puts the flexible board 30 in a predetermined shape so as to determine a direction of a radio wave transmitted from the antenna 40. Thus, the support 60 is formed of a material that is harder than that of the flexible board 30. Note that examples of a material of the support 60 include ceramic, glass, polyether, ether ketone resin, epoxy glass, metal (stainless steel, aluminum, iron, a copper-zinc alloy, gold, silver, brass, titanium, and steel), and plastic.

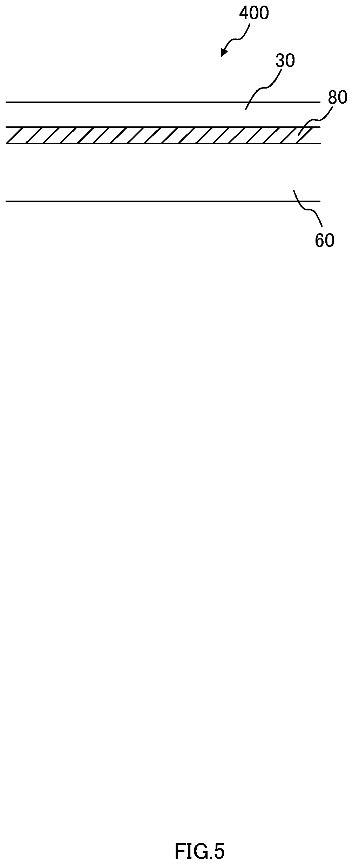

When the support 60 is attached to the back surface of the flexible board 30, the support 60 has a shape that supports a region around the flexible board 30 except for the region 200, and includes support parts 300 to 302. The support part 300 supports an end part of the flexible board 30 on the side thereof opposite to the connector 50 side. The support part 301 supports one of end parts along a longitudinal direction of the flexible board 30, and the support part 302 supports the other end part along the longitudinal direction of the flexible board 30. In other words, the support 60 has a shape (a substantially U-shaped planar shape) along sides to which the connector 50 is not attached. Then, the support 60 is attached to the flexible board 30 via an adhesive. In an embodiment of the present disclosure, the adhesive is applied to an overlapping part 400 illustrated in Fig. 1 in which the support 60 and the flexible board 30 overlap each other. Fig. 5 is a schematic diagram for illustrating a bonding state. As illustrated in Fig. 5, an adhesive 80 is interposed between the support 60 and the flexible board 30. Note that a material having high heat conductivity and having a heat dissipation property is used as the adhesive 80 (heat-dissipating member) . Here, examples of the material having a heat dissipation property include silver paste, heat conductive silicone, a heat-dissipating sheet, heat conductive epoxy resin, and heat conductive acrylic resin. Note that the adhesive 80 is applied to the overlapping part 400, but may also be applied between the support 60 and the connector 50 such that the support 60 and the connector 50 are fixed, for example.

When such a support 60 is attached to the flexible board 30, the flexible board 30 has a substantially flat shape without a warp, as illustrated in Fig. 1. Thus, a direction of the antenna is substantially constant. The support 60 has a shape that supports a region except for the region 200 of the back surface of the flexible board 30, namely, a shape that does not entirely cover the region 200. Thus, a dielectric loss occurring via the region 100, in which the antenna 40 and the like are formed, and the region 200 is reduced. Therefore, the antenna device 10 can reduce a dielectric loss while determining a direction (a radiation direction of a radio wave) of the antenna 40 formed on the flexible board 30.

### Antenna Device 11 (Second Embodiment)

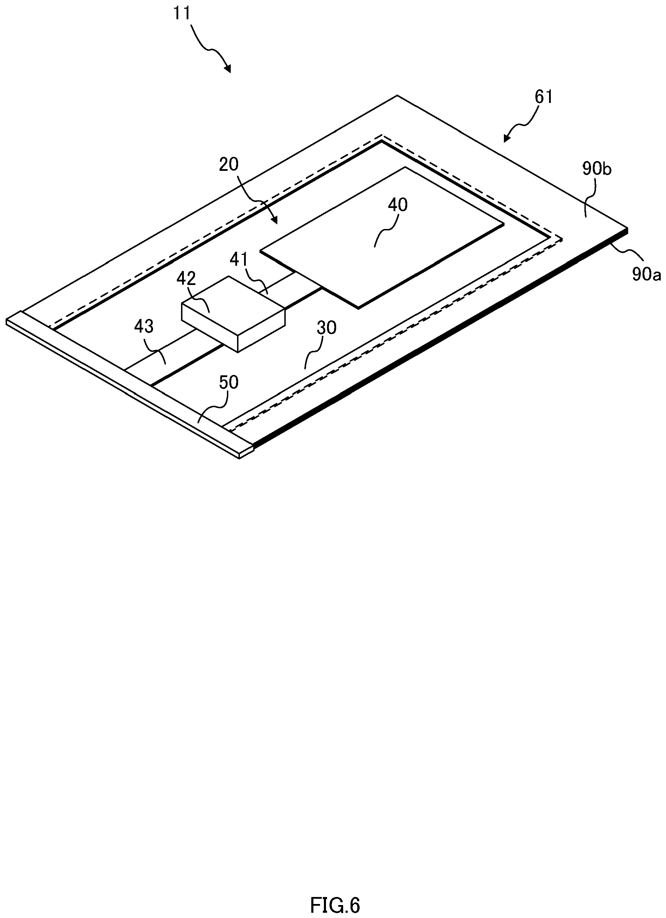

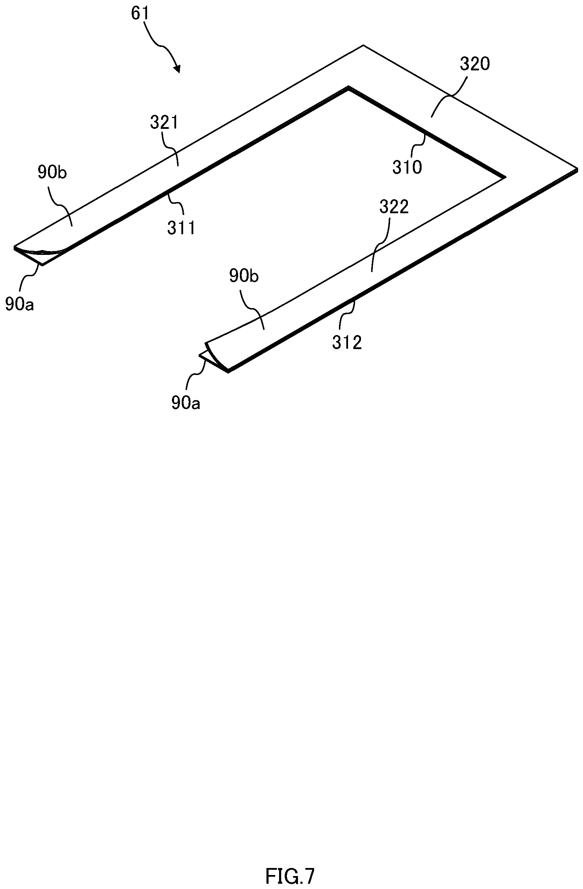

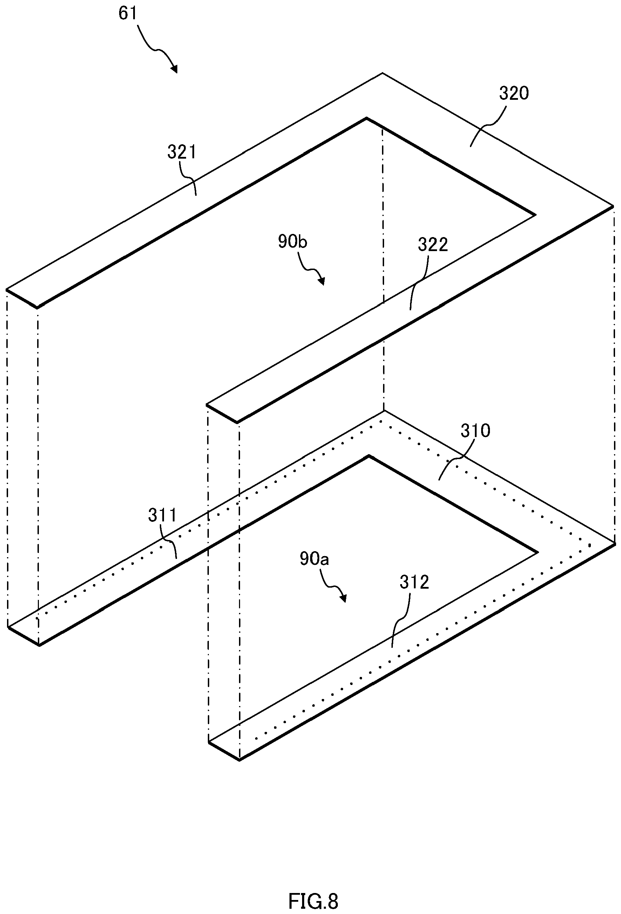

Fig. 6 is a perspective view illustrating a configuration of an antenna device 11. The antenna device 11 includes a board unit 20 and a support 61. Note that the board unit 20 is the same as that used in the antenna device 10, and thus detailed description is omitted herein. Fig. 7 is a perspective view of the support 61, and Fig. 8 is an exploded perspective view of the support 61.

Similarly to the support 60, the support 61 is a member that puts a flexible board 30 in a predetermined shape to determine a direction of a radio wave transmitted from the antenna 40. The support 61 includes fixing members 90a and 90b.

The fixing member 90a is a member similar to the support 60, and includes support parts 310 to 312 similar to the support parts 300 to 302.

The fixing member 90b is a member having the same shape as that of the fixing member 90a, and sandwiches and fixes the flexible board 30 with the fixing member 90a. The fixing member 90b includes covers 320 to 322. In an embodiment of the present disclosure, the fixing member 90a and the fixing member 90b overlap each other, and are fixed with an adhesive such that the flexible board 30 can be inserted between the fixing members 90a and 90b. Note that Fig. 7 illustrates a state where a part of the fixing member 90b is lifted up in order to facilitate understanding of a configuration of the support 61. In an embodiment of the present disclosure, as indicated by a dotted line on a surface (a surface overlapping the fixing member 90b) of the fixing member 90a in Fig. 8, an adhesive is applied along an outer side in a longitudinal direction of each of the support parts 310 to 312, and the fixing members 90a and 90b are fixed.

As a result, when the flexible board 30 is inserted between the fixing members 90a and 90b, the support part 310 and the cover 320 sandwich and fix an end part of the flexible board 30 on the side thereof opposite to the connector 50 side. The support part 311 and the cover 321 sandwich and fix one of end parts of the flexible board 30 along its longitudinal direction. Furthermore, the support part 312 and the cover 322 sandwich and fix the other end part of the flexible board 30 along the longitudinal direction.

When the flexible board 30 is inserted into such a support 61, the flexible board 30 has a substantially flat shape without distortion, as illustrated in Fig. 6. The support 61 has a shape that sandwiches a region except for a region 200 of a back surface of the flexible board 30, namely, a shape that does not entirely cover the region 200. Thus, a dielectric loss occurring via the region 200 and a region 100 in which an antenna 40 and the like are formed is reduced. Therefore, the antenna device 11 can reduce a dielectric loss while determining the direction of the antenna 40.

Note that the adhesive for fixing the fixing members 90a and 90b is similar to the adhesive 80. The fixing members 90a and 90b may be fixed with a tape or the like such that the flexible board 30 can be inserted between the fixing members 90a and 90b. The adhesive may be applied between the support 61 and the connector 50 such that the support 61 and the connector 50 are fixed. Furthermore, for example, the inserted flexible board 30 may be fixed to the fixing members 90a and 90b with the adhesive.

### Antenna Device 12 (Third Embodiment)

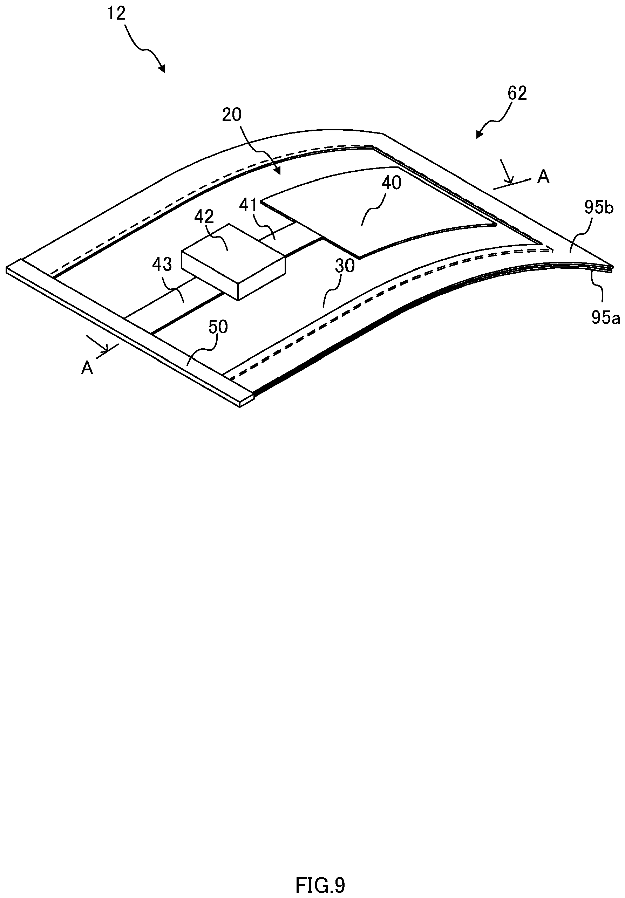

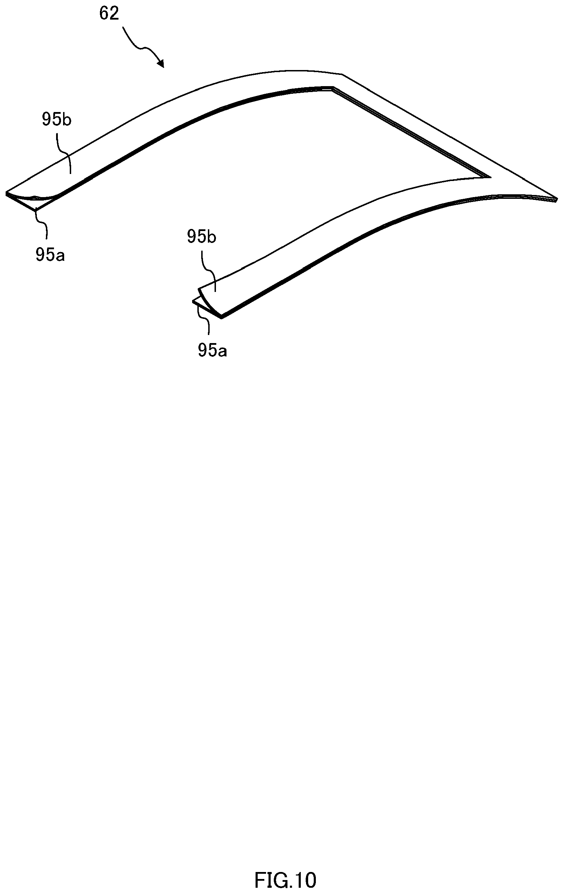

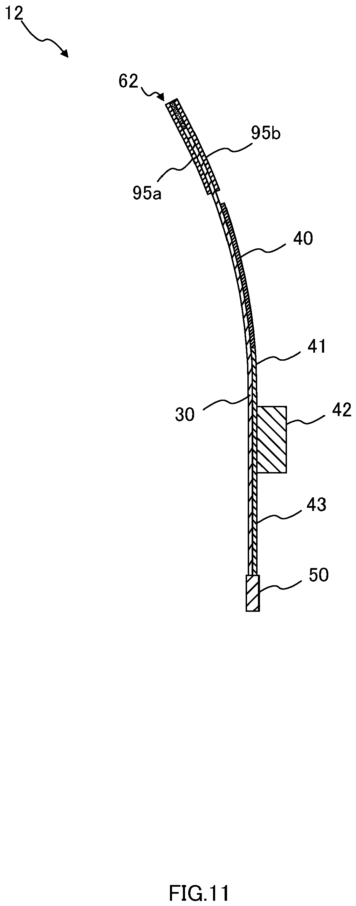

Fig. 9 is a perspective view illustrating a configuration of an antenna device 12. The antenna device 12 includes a board unit 20 and a support 62. Note that the board unit 20 is the same as that used in the antenna device 10, and thus detailed description is omitted herein. Fig. 10 is a perspective view of the support 62. Fig. 11 is a cross-sectional view of the antenna device 12 taken along an A-A line of Fig. 9. Note that the thicknesses of an antenna 40, a signal line 41, and a wiring 43 are thinner than the thicknesses of fixing members 95a and 95b, but Fig. 11 illustrates them with substantially the same thicknesses in order to facilitate understanding of each configuration. An adhesive is provided between the fixing members 95a and 95b.

Similarly to the support 61, the support 62 is a member that puts a flexible board 30 in a predetermined shape so as to determine a direction of a radio wave transmitted from the antenna 40. The support 62 includes the fixing members 95a and 95b.

The fixing members 95a and 95b are respectively similar to the fixing members 90a and 90b of the support 61 illustrated in Figs. 6 to 8. However, the support 62, namely, the fixing members 95a and 95b in an embodiment of the present disclosure are formed of a flexible material (for example, metal). The fixing members 95a and 95b are bent such that the antenna 40 can radiate a radio wave in a predetermined direction when the antenna device 12 has been mounted. Specifically, as illustrated in Fig. 11, the support 62 is bent such that a longitudinal direction of the flexible board 30 warps toward the back surface side of the flexible board 30. In this way, in the antenna device 12, the support 62 can be bent, and thus the direction of the antenna 40 can be adjusted to a direction suitable for communication. Note that, here, the support 62 is bent before the flexible board 30 is inserted, but may be bent after the flexible board 30 is inserted.

### Another Embodiment of Support

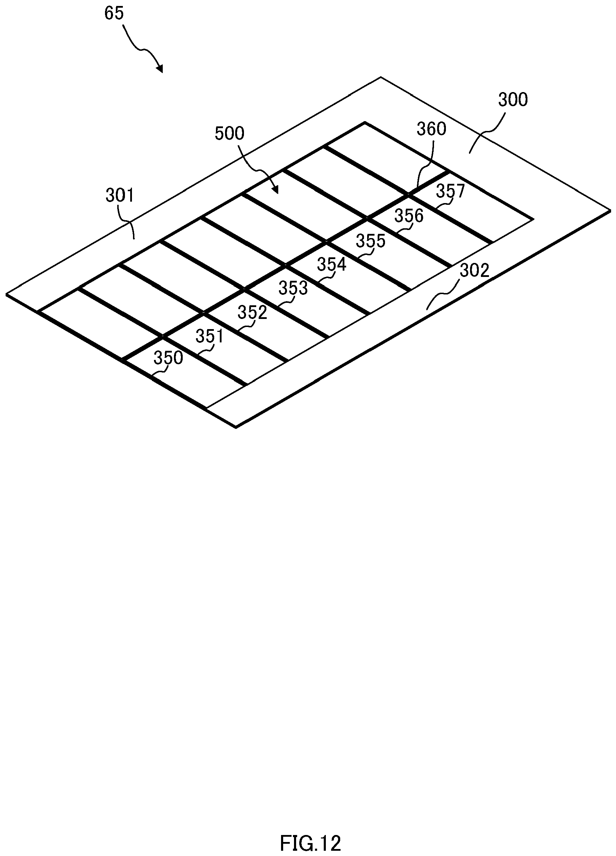

Fig. 12 is a perspective view of a support 65. Similarly to the support 60, the support 65 is a member that puts a flexible board 30 in a predetermined shape. The support 65 includes support parts 350 to 357 and 360 in addition to the same support parts 300 to 302 as those of the support 60.

The support parts 350 to 357 are rod-shaped members provided between the support parts 301 and 302 to support a bottom surface of the flexible board 30. The support parts 350 to 357 are provided substantially in parallel in a longitudinal direction of the support part 300.

The support part 360 is a rod-shaped member provided along a longitudinal direction of the support parts 301 and 302 in a substantially middle position of a space 500 between the support parts 301 and 302. Note that the support parts 350 to 357 are disposed at regular intervals so as to intersect the support part 360 in a cross shape.

For example, even when the support 65 is used instead of the support 60 in the antenna device 10 in Fig. 1, the support parts 350 to 357 and 360 does not entirely cover the region 200. Therefore, even in such a case, a dielectric loss can be reduced as compared to a case where the entire back surface of the region 200 is covered with a rigid board.

Note that support parts (for example, the support parts 354 to 357 and 360) that cover a part of the region 200 are provided in the support 65 in Fig. 12, but a support without these support parts may be used. In such a case, a dielectric loss can be further reduced. The support parts 350 to 357 and 360 (a plurality of rod-shaped members) are provided in the space 500 in the support 65, but the present disclosure is not limited thereto. For example, mesh-shaped or net-shaped support members or a flat plate provided with a hole corresponding to the region 200 may be provided in the space 500 instead of the support parts 350 to 357 and 360.

### Summary

As described above, the antenna device 10 and the like in an embodiment of the present disclosure are described. When, for example, the support 65 is used in the antenna device 10, the region 200 of the back surface of the flexible board 30 is not entirely covered. Therefore, in such a case, a dielectric loss can be reduced as compared to a case where the entire back surface of the region 200 is covered with a rigid board. Note that, when the support 65 is used, the flexible board 30 has a substantially flat shape without distortion, similarly to the case of the support 60. Thus, in such a case, a direction of the antenna 40 formed on the flexible board 30 can be determined (stabilized).

Further, for example, the support 60 has a shape that does not entirely cover the region 200. Thus, when using the support 60 illustrated in Fig. 1 and the like, a dielectric loss can be further reduced as compared to a case of using the support 65.

A liquid crystal polymer having a dielectric constant of about 3.0 is used for the flexible board 30. As a material of the support 60 and the like, a material (for example, fluoropolymer: dielectric constant of 2.1 to 2.6) having a dielectric constant lower than a dielectric constant of the flexible board 30 is preferable. An effect of a dielectric loss can be further reduced by using the support 60 of such a material. Note that, for example, a polyimide and fluororesin may also be used for the flexible board 30.

The support 62 is bent such that a radio wave from the antenna 40 is radiated in a predetermined direction. Optimization of a direction of the antenna can be achieved by using such a support 62.

The support 62 is formed of a flexible material such as metal. Thus, even after the antenna device 12 is mounted, optimization of a direction of the antenna can be achieved by changing (bending) a shape of the support 62.

In the support 60, the adhesive 80 (heat-dissipating member) having a heat dissipation property is provided between the flexible board 30 and the support 60. The IC 42 that processes a signal in a millimeter wave band generally has great power consumption, and thus also has a great heating value. In an embodiment of the present disclosure, the heat of the flexible board 30 can be transferred to the support 60 via the adhesive 80, and thus the support 60 functions as a so-called heat-dissipating plate. Thus, a rise in temperature of the antenna device 10 can be reduced by using the adhesive 80 having high heat conductivity.

Note that the foregoing embodiments are for facilitating the understanding of the present disclosure, and are not to be construed as limiting the present disclosure. The present disclosure may be modified and/or improved without departing from the gist thereof, and the present disclosure encompasses any equivalents thereof.

For example, the support 60 is provided to surround the flexible board 30 except for the connector 50 in an embodiment of the present disclosure, but the present disclosure is not limited thereto. Specifically, the support may be able to put the flexible board 30 in a predetermined shape (shape that can stably radiate a radio wave) . Thus, the support may not support the flexible board 30 up to the end part thereof on the connector 50 side in the longitudinal direction of the flexible board 30.

The antenna 40 having a substantially rectangular shape is used in an embodiment of the present disclosure, but the present disclosure is not limited thereto. For example, a pattern antenna having another shape such as a square and a circle may be used. Even in such a case, an effect similar to that of the antenna device 10 and the like can be achieved, as long as a support does not cover at least a part of a region of a back surface that corresponds to a region of a pattern formed as an antenna.

### Reference Signs List

- 10 to 12:: Antenna device;
- 20:: Board unit;
- 30:: Flexible board;
- 40:: Antenna;
- 41:: Signal line;
- 42:: IC;
- 43:: Wiring;
- 50:: Connector;
- 60 to 62, 65:: Support;
- 80:: Adhesive;
- 90a, 90b, 95a, 95b:: Fixing member;
- 100, 200:: Region;
- 300 to 302, 310 to 312, 350 to 357, 360:: Support part;
- 320 to 322:: Cover;
- 400:: Overlapping part;
- 500:: Space.

## Claims

1. An antenna device comprising:
a flexible board including an antenna and a signal line coupled to the antenna, the antenna and the signal line being formed on a front surface side of the flexible board; and
a support that puts the flexible board in a predetermined shape,
the support having a shape that does not cover at least a part of a second region of a back surface of the flexible board, the second region corresponding to a first region in which the antenna and the signal line are formed.

2. The antenna device according to claim 1, wherein
the support has a shape that does not entirely cover the second region.

3. The antenna device according to claim 1 or 2, wherein
the support has a dielectric constant lower than a dielectric constant of the flexible board.

4. The antenna device according to claims 1 to 3, wherein
the support is bent such that the antenna can radiate a radio wave in a predetermined direction when the antenna device has been mounted.

5. The antenna device according to claims 1 to 4, wherein
the support is formed of a flexible material.

6. The antenna device according to claims 1 to 5, further comprising
a heat-dissipating member interposed between the flexible board and the support.
